# FASCICULE DE BREVET EUROPEEN

(11) **EP 1 404 016 B1**
(45) Date de publication et mention de la délivrance du brevet: **13.02.2008**
(21) Numéro de dépôt: 03292192.6
(22) Date de dépôt: 05.09.2003
(51) Int. Cl.: H02P 6/16

(54) **Dispositif de pilotage d'un moteur à commutation électronique comprenant des singularités réparties angulairement.**
Vorrichtung zur Steuerung eines elektronischen kommutierten Motor mit winkelverteilten Singularitäten
Device for controlling an electronically-commutated motor comprising angularly distributed singularities

(30) Priorité: 27.09.2002 FR 0212015
(43) Date de publication de la demande: 31.03.2004
(73) Titulaire: SNR ROULEMENTS, F-74010 Annecy Cedex (FR)
(72) Inventeur: Desbiolles, Pascal, 74570 Thorens-Glieres (FR); Duret, Christophe, 74000 Annecy (FR)
(74) Mandataire: Geismar, Thierry

(56) Documents cités:
- EP-A- 0 607 719
- EP-A- 0 780 964
- FR-A- 2 769 088
- US-B1- 6 400 109

## Description

L'invention concerne un dispositif de pilotage d'un moteur électrique de type à commutation électronique comprenant N paires de pôles et P phases, un roulement et un moteur équipé d'un tel dispositif, ainsi qu'un procédé de pilotage d'un tel moteur

Du fait de leur puissance massique importante, les moteurs à commutation électronique, ou moteurs brushless, peuvent être utilisés pour commander la rotation d'un organe mécanique dans un grand nombre d'applications.

Un exemple particulier d'une telle application est l'assistance à la direction des véhicules automobiles par un système de direction assistée de type électrique.

Dans le cadre de cette application, il est nécessaire de piloter précisément la commutation du courant dans les phases de ces moteurs afin d'obtenir un couple qui soit optimal.

Il est connu d'utiliser un dispositif de pilotage comprenant un capteur pourvu de P éléments sensibles disposés en regard d'un codeur comportant N paires de pôles, ledit codeur étant mis en rotation par le moteur.

Dans le cas d'un moteur brushless DC à trois phases, en prévoyant que les trois éléments sensibles soient déphasés l'un par rapport à l'autre d'un angle mécanique permettant de fournir trois signaux électriques de commutation qui sont déphasés de 120° électriques, il est possible de piloter la commutation entre les phases du moteur.

Toutefois, ce type de solution ne permet qu'une précision limitée dans la détermination des instants de commutation du courant dans les phases.

En effet, dans les dispositifs de pilotage connus, la précision des signaux de commutation est fonction des tolérances de réalisation et d'aimantation des codeurs magnétiques et de positionnement des éléments sensibles sur leur support, ces deux facteurs ne pouvant être obtenus qu'avec des tolérances non nulles.

Par conséquent, du fait de ces tolérances, la précision du déphasage entre les signaux de commutation n'est pas exactement de 120° électriques, ce qui induit des modulations indésirables du couple fourni par le moteur.

Pour résoudre ce problème, on a proposé des dispositifs de pilotage comprenant un deuxième capteur de type « resolver » qui permet de connaître la position absolue du rotor afin d'améliorer la précision de pilotage du moteur.

Toutefois, ce type de solutions n'est pas satisfaisant en ce qu'il induit des contraintes d'intégration mécanique du fait de l'encombrement des capteurs de type « resolver ». De plus, s'ajoute la difficulté à transporter les signaux analogiques issus du resolver vers un démodulateur calculant la position absolue du rotor.

Pour pallier notamment cet inconvénient, l'invention propose un dispositif de pilotage qui utilise un signal de position absolue du rotor pour piloter la commutation des courants dans les enroulements de phase du moteur, ladite position absolue étant obtenue avec un seul ensemble capteur / codeur. En outre, lors de sa mise en service, le dispositif de pilotage suivant l'invention permet d'obtenir la position angulaire absolue du rotor dès que le rotor a tourné d'un angle inférieur à la largeur angulaire des paires de pôles du moteur.

A cet effet, et selon un premier aspect, l'invention propose un dispositif de pilotage d'un moteur électrique de type à commutation électronique comprenant N paires de pôles et P phases, ledit dispositif comprenant :
- un codeur destiné à être mis en rotation conjointement au rotor du moteur, ledit codeur comprenant une piste multipolaire principale et une piste multipolaire dite « top tour » qui sont concentriques, lesdites pistes comprenant chacune N secteurs identiques répartis angulairement respectivement sur toute la circonférence desdites pistes, les secteurs de la piste top tour comprenant chacun M singularités réparties angulairement, les distances angulaires séparant chacune des M singularités (2b1) étant différentes les unes des autres ;
- un capteur fixe disposé en regard et à distance d'entrefer du codeur, comprenant au moins trois éléments sensibles dont au moins deux sont positionnés en regard de la piste principale de sorte à délivrer deux signaux électriques S1, S2 périodiques en quadrature et au moins un est positionné en regard de la piste top tour de sorte à délivrer un signal électrique S3, le capteur comprenant un circuit électronique apte, à partir des signaux S1, S2 et S3, à délivrer deux signaux digitaux de position A, B carrés en quadrature qui sont représentatifs de la position angulaire du rotor et un signal top tour C sous forme de N*M impulsions par tour du codeur, les M singularités étant réparties angulairement de sorte que le signal top tour C soit agencé pour, en combinaison avec les signaux A et B, définir des séquences binaires de longueur angulaire inférieure à celle d'un secteur et qui sont représentatives de la position angulaire absolue du codeur sur un secteur ;
- un circuit de commutation des courants dans les enroulements de phase du moteur qui comprend 2*P*N interrupteurs ;
- un circuit de commande du circuit de commutation qui est apte :
   - lors de la lecture d'une séquence binaire du signal top tour C, à déterminer l'état de la logique de commutation des courants dans les enroulements de phase qui correspond à la position angulaire absolue associée à ladite séquence binaire ;
   - en fonction des signaux de position A, B détectés, à déterminer en continu l'état de la logique de commutation qui est adapté à la position angulaire du rotor ;
   - à fournir les signaux de commutation des interrupteurs qui correspondent à l'état de la logique déterminée par le signal top tour C ou par les signaux de position A, B.

Selon un deuxième aspect, l'invention propose un roulement, du type comprenant une bague fixe destinée à être associée à un organe fixe, une bague tournante destinée à être mise en rotation par le rotor du moteur électrique et des corps roulants disposés entre lesdites bagues, dans lequel le codeur d'un tel dispositif est associé à la bague tournante.

Selon un troisième aspect, l'invention propose un moteur à commutation électronique équipé d'un tel dispositif de pilotage, du type comprenant un rotor monté en rotation par l'intermédiaire d'un tel roulement, dans lequel le capteur est associé à la bague fixe.

En variante, le capteur du dispositif de pilotage est associé à uns pièce fixe du moteur.

Selon une autre réalisation, le codeur du dispositif de pilotage est associé au rotor du moteur.

Selon un quatrième aspect, l'invention propose un procédé de pilotage d'un tel moteur qui comprend les étapes successives suivantes :
- application d'un couple sur le rotor de sorte à permettre sa mise en rotation et donc celle du codeur ;
- détection de la première séquence binaire;
- détermination de l'état de la logique de commutation correspondant à la position angulaire absolue associée à ladite séquence binaire ;
- envoi au circuit de commutation des signaux de commutation correspondant à l'état déterminé ;
- détermination itérative des états de la logique de commutation ultérieurs à partir des signaux de position A, B ;
- envoi au circuit de commutation des signaux de commutation correspondants aux états déterminés.

D'autres objets et avantages de l'invention apparaîtront au cours de la description qui suit, faite en référence aux dessins annexés, dans lesquels :
- la figure 1 est une vue de face d'un codeur comprenant une piste multipolaire principale et une piste multipolaire top tour ;
- la figure 2 est une vue en coupe longitudinale d'un roulement pourvu d'un codeur tel que celui représenté sur la figure 1 ;
- la figure 3 est une vue partielle et en coupe longitudinale d'un moteur suivant l'invention.

L'invention concerne un dispositif de pilotage d'un moteur à commutation électronique ou moteur brushless comprenant N paires de pôles et P phases.

Ce type de moteur comprend typiquement un rotor 1 portant les N paires de pôles magnétiques Nord/Sud et un stator portant P bobines formées respectivement d'un enroulement de phase, le rotor 1 étant mis en rotation de façon connue en pilotant l'alimentation électrique dans les P enroulements de phases.

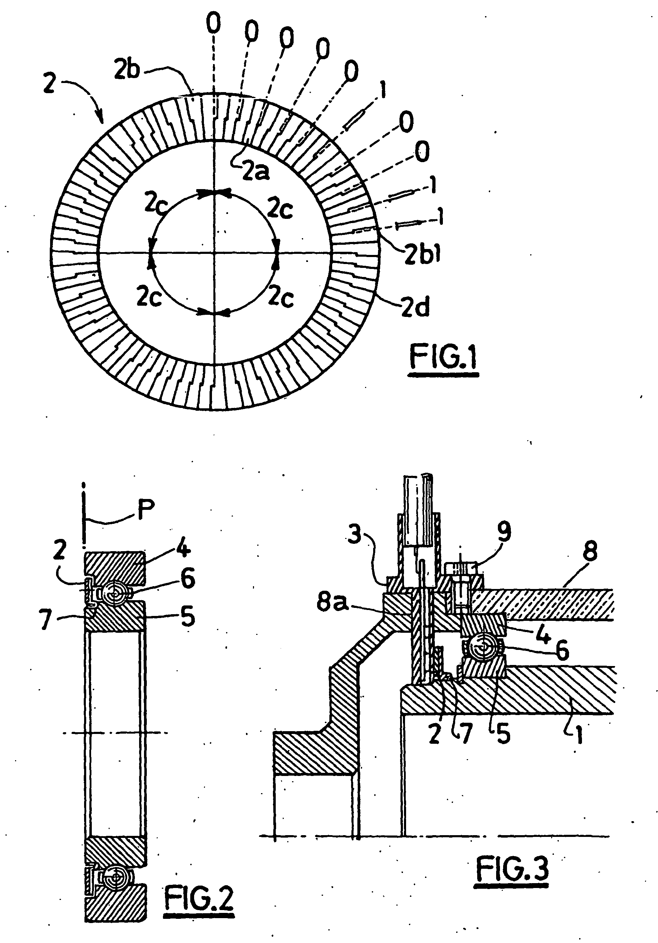

Le dispositif de pilotage comprend un codeur 2, tel que celui représenté sur la figure 1, qui comprend une piste multipolaire principale 2a et une piste multipolaire 2b dite « top tour » qui sont concentriques. Les pistes comprennent N secteurs 2c identiques répartis angulairement respectivement sur toute la circonférence desdites pistes, les secteurs de la piste top tour 2b comprenant chacun M singularités 2b1 réparties angulairement. Le codeur 2 est destiné à effectuer, conjointement au rotor 1, une pluralité de tours autour de son axe de rotation.

Dans un exemple particulier, le codeur 2 est formé d'un anneau magnétique multipolaire sur lequel est aimantée une pluralité de paires de pôles 2d Nord et Sud équiréparties avec une largeur angulaire constante de sorte à former les pistes principale 2a et top tour 2b, une singularité magnétique 2b1 de la piste top tour 2b étant formée de deux pôles adjacents dont la transition magnétique est différente des autres.

Suivant la réalisation représentée sur la figure 1 (P=3, N=4), les pistes principale 2a, disposée vers l'intérieur de l'anneau 2, et top tour 2b, disposée vers l'extérieur de l'anneau 2, comprennent 40 paires de pôles 2d qui sont réparties en 4 secteurs 2c de 10 paires de pôles chacun. Les paires de pôles 2d de la piste top tour 2b sont en retard de phase d'une valeur φ par rapport à celles de la piste principale 2a.

Chaque secteur 2c de la piste top tour 2b comprend 3 singularités magnétiques 2b1 qui sont réparties angulairement avec des distances différentes entre elles.

Chaque singularité 2b1 est formée d'une paire de pôles 2d, la largeur des pôles étant agencée pour qu'un pôle soit déphasé de -φ par rapport au pôle correspondant de la piste principale 2a. Ainsi, chaque impulsion du signal C correspond à la détection d'une inversion de déphasage entre la piste principale 2a et la piste top tour 2b.

Le dispositif de pilotage comprend en outre un capteur 3 fixe disposé en regard et à distance d'entrefer du codeur 2.

Le capteur 3 comprend au moins trois éléments sensibles dont au moins deux sont positionnés en regard de la piste principale 2a et au moins un est positionné en regard de la piste top tour 2b.

Dans un exemple particulier, les éléments sensibles sont choisis dans le groupe comprenant les sondes à effet Hall, les magnétorésistances, les magnétorésistances géantes.

Le capteur 3 utilisé est apte à délivrer deux signaux électriques S1, S2 périodiques en quadrature par l'intermédiaire des éléments sensibles disposés en regard de la piste principale 2a et un signal électrique S3 par l'intermédiaire des éléments sensibles disposés en regard de la piste top tour 2b.

Le principe d'obtention des signaux S1 et S2 à partir d'une pluralité d'éléments sensibles alignés est par exemple décrit dans le document FR-2 792 403 issu de la demanderesse.

Mais des capteurs 3 comprenant deux éléments sensibles qui sont aptes à délivrer les signaux S1 et S2 sont également connus.

Le capteur 3 comprend en outre un circuit électronique qui, à partir des signaux S1, S2 et S3, délivre des signaux digitaux de position A, B carrés en quadrature et un signal top tour C sous forme de M*N impulsions électriques par tour du codeur 2.

Un principe d'obtention des signaux digitaux A, B et C, ainsi que différents modes de réalisation des singularités magnétiques 2b1, sont décrits dans les documents FR-2 769 088 et EP-0 871 014.

Suivant une réalisation, le capteur 3 comprend en outre un interpolateur, par exemple du type décrit dans le document FR-2 754 063 issu de la demanderesse, permettant d'augmenter la résolution des signaux de sortie.

Le capteur 3 peut être intégré sur un substrat en silicium ou équivalent par exemple AsGa, de sorte à former un circuit intégré et personnalisé pour une application spécifique, circuit parfois désigné sous le terme ASIC pour faire référence au circuit intégré conçu partiellement ou complètement en fonction des besoins.

Bien que la description soit faite en relation avec un ensemble codeur/capteur magnétique, il est également possible de mettre en oeuvre l'invention de façon analogue er utilisant une technologie de type optique. Par exemple, le codeur 2 peut être formé d'une cible en métal ou en verre sur laquelle les pistes principale 2a et top tour 2b ont été gravées de sorte à former un motif optique analogue au motif magnétique multipolaire exposé ci-dessus, les éléments sensibles étant alors formés de détecteurs optiques.

Dans le mode de réalisation représenté sur la figure 1, la répartition angulaire des trois singularités de la piste top tour 2b peut être représentée par le motif binaire 0000010011 obtenu par exploitation du signal C et des signaux A et B lors de la rotation le long d'un secteur 2c, où le chiffre 1 correspond à la détection d'une singularité sur le signal C et le chiffre 0 à l'occurrence inverse, les chiffres 0 et 1 étant affectés respectivement sur les paires de pôles qui sont discriminées au moyen des signaux A et B.

Avec ce motif binaire, il est possible d'établir, en fonction de la position initiale du codeur 2 et du sens de rotation, le nombre d'états 0 ou 1 à lire pour déterminer de façon univoque la position absolue du codeur 2 sur un secteur 2c. Dans la suite de la description, cette succession de 0 ou 1 qui permet de déterminer une position absolue du codeur 2 sur un secteur 2c, est appelée séquence binaire.

Par exemple, en partant de la position du premier 0 du motif binaire, pour connaître de façon univoque la position absolue du codeur 2 sur un secteur 2c, il faut :
- en tournant vers la droite, lire la séquence binaire 00001 ;
- en tournant vers la gauche, lire la séquence binaire 110 ;
- en tournant alternativement vers la gauche et vers la droite, lire la séquence binaire 11000.

En effectuant cette analyse pour l'ensemble des positions initiales possibles, on détermine la longueur maximale de la séquence binaire et donc la rotation maximale à effectuer pour connaître la position absolue du codeur 2 sur un secteur 2c. Dans l'exemple de la figure 1, il faut, dans le pire des cas, une rotation de 5 paires de pôles du codeur, soit 45° mécaniques, pour connaître de façon univoque la position absolue du codeur 2 sur un secteur 2c.

Selon l'invention, il est donc possible, si la longueur angulaire de la séquence binaire est inférieure à celle du secteur 2c, de connaître la position absolue du codeur 2, et donc celle du rotor 1 associé, dès que celui-ci a tourné d'un angle inférieur à la largeur angulaire des paires de pôles du moteur.

En fonction des besoins spécifiques de chaque application, il est possible de répartir les singularités différemment sur la piste top tour 2b de sorte soit à augmenter soit à diminuer la longueur maximale des séquence binaires. En outre, il est également possible de faire varier le nombre de paires de pôles du codeur par secteur 2c et donc d'obtenir un motif binaire plus ou moins long, et/ou de faire varier les dimensions du codeur 2.

Le dispositif de commande comprend en outre un circuit de commutation des courants dans les enroulements de phase du moteur.

Le circuit de commutation comprend 2*P*N interrupteurs, par exemple formés chacun d'un transistor à effet de champ de type MOSFET fonctionnant à 20 kHz, qui sont disposés en pont de sorte à alimenter les enroulements de phases de façon appropriée.

Les 2*P*N interrupteurs peuvent être actionnés deux à deux suivant une logique de commutation comprenant 2*P*N états possibles.

La commande du dispositif de commutation, c'est à dire l'actionnement sélectif des interrupteurs, est effectuée par un circuit de commande qui est apte :
- lors de la lecture d'une séquence binaire, à déterminer l'état de la logique de commutation des courants dans les enroulements de phase qui correspond à la position angulaire absolue associée à ladite séquence binaire ;
- en fonction des signaux de position A, B détectés, à déterminer en continu l'état de la logique de commutation qui est adapté à la position angulaire du rotor 1 ;
- à fournir les signaux de commutation des interrupteurs qui correspondent à l'état de la logique déterminée par le signal top tour C ou par les signaux de position A, B.

Le circuit de commande peut être réalisé sous la forme d'un microprocesseur intégrant au moins une logique de commutation du circuit de commutation qui détermine la succession des ouvertures/fermetures des différents interrupteurs.

On décrit ci-dessous, le fonctionnement du dispositif de pilotage.

Initialement, c'est-à-dire lors de la mise en service du dispositif, un couple est appliqué sur le rotor 1 de sorte à permettre sa mise en rotation et donc celle du codeur 2.

En particulier, dans le cas de l'utilisation du dispositif de pilotage dans une direction assistée électrique pour véhicule automobile, le couple peut être appliqué par l'intermédiaire du volant sans qu'un couple d'assistance ne soit fourni.

En effet, dans cette application et avec le codeur représenté sur la figure 1, l'angle de braquage sans assistance sera au maximum de 3 degrés en supposant que la direction assistée électrique ait un rapport de réduction de 15, ce qui est tout à fait acceptable.

En variante, le moteur peut être initialement alimenté en courant par une séquence de pilotage préétablie, de sorte à permettre la mise en rotation du rotor 1 et donc celle du codeur 2.

Dès la détection de la première séquence binaire, le circuit de commande détermine l'état de la logique de commutation des courants dans les enroulements de phases qui correspond à la position angulaire associée à ladite séquence binaire et envoie au circuit de commutation les signaux de commutation correspondants.

Ensuite, les signaux de position A, B permettent de connaître la position absolue du rotor 1, c'est-à-dire la position par rapport à celle associée à ladite séquence binaire détectée, de sorte à déterminer en continu l'état de la logique de commutation qui est adapté. En effet, à chaque position du rotor 1, correspond un état de la logique de commutation qui permet d'obtenir un couple moteur optimal. Le circuit de commande peut donc fournir, au circuit de commutation, les signaux de commutation des interrupteurs qui correspondent à l'état de la logique déterminé.

En variante, il peut être prévu une étape préalable d'indexation angulaire des impulsions top tour par rapport au passage à zéro des forces électromotrices dans les phases du moteur, c'est-à-dire l'indexation des positions angulaires des singularités 2b1 par rapport à celles des paires de pôles du moteur. Cette étape peut être réalisée en sortie de chaîne et sur un banc dédié, la valeur des déphasages pouvant être mémorisée dans une mémoire de type EEPROM ou flash du circuit de commande de sorte à permettre le recalage des instants de commutation de façon électronique. Cette mémorisation permet de s'affranchir d'une indexation mécanique du codeur qui se révèle difficile et onéreuse.

Suivant l'invention, la précision dans la détermination des instants de commutation n'est donc limitée que par la précision de la mesure de la position angulaire du rotor 1.

En outre, dès que le codeur 2 a tourné d'un angle qui est modulable en fonction de la répartition des singularités 2b1, le pilotage du moteur peut se faire de façon optimale.

En relation avec la figure 2, on décrit un roulement comprenant une bague extérieure fixe 4 destinée à être associée à un organe fixe, une bague intérieure tournante 5 destinée à être mise en rotation par le rotor 1 du moteur électrique et des corps roulants 6 disposés entre lesdites bagues.

Dans le mode de réalisation représenté, le codeur 2 est surmoulé sur une portée cylindrique annulaire d'une armature 7 qui est associée, par exemple par emmanchement, sur une face de la bague intérieure 5.

Le codeur 2 est associé à la bague tournante 5 de sorte que la face extérieure dudit codeur soit sensiblement contenue dans le plan P d'une face latérale de la bague fixe 4. Cette caractéristique, notamment divulguée dans le document EP-0 607 719 issu de la demanderesse, permet d'une part de protéger le codeur 2 à l'intérieur du roulement et d'autre part de pouvoir dissocier le capteur 3 du roulement en gardant la maîtrise de l'entrefer.

En relation avec la figure 3, on décrit un moteur à commutation électronique comprenant un rotor 1 monté en rotation par l'intermédiaire d'un roulement. A cet effet, la bague extérieure 4 du roulement est associée au carter 8 du moteur et la bague intérieure 5 est associée, par exemple par emmanchement, au rotor 1 dudit moteur. Le capteur 3 est disposé dans une fente 8a du carter 8 et est associé audit carter par une vis 9. En variante, on peut prévoir que le capteur 3 soit associé à la bague extérieure 4 du roulement.

Par ailleurs, le codeur 2 est associé au rotor 1. A cet effet, l'armature 7 est par exemple emmanchée sur une portée prévue sur la périphérie du rotor 1.

## Revendications

1. Dispositif de pilotage d'un moteur électrique de type à commutation électronique comprenant N paires de pôles et P phases, ledit dispositif comprenant :
- un codeur (2) destiné à être mis en rotation conjointement au rotor (1) du moteur, ledit codeur comprenant une piste multipolaire principale (2a) et une piste multipolaire (2b) dite « top tour » qui sont concentriques, lesdites pistes comprenant chacune N secteurs (2c) identiques répartis angulairement respectivement sur toute la circonférence desdites pistes, les secteurs (2c) de la piste top tour (2b) comprenant chacun M singularités (2b1) réparties angulairement, les distances angulaires séparant chacune des M singularités (2b1) étant différentes les unes des autres ;
- un capteur (3) fixe disposé en regard et à distance d'entrefer du codeur (2), comprenant au moins trois éléments sensibles dont au moins deux sont positionnés en regard de la piste principale (2a) de sorte à délivrer deux signaux électriques S1, S2 périodiques en quadrature et au moins un est positionné en regard de la piste top tour (2b) de sorte à délivrer un signal électrique S3, le capteur (3) comprenant un circuit électronique apte, à partir des signaux S1, S2 et S3, à délivrer deux signaux digitaux de position (A, B) carrés en quadrature qui sont représentatifs de la position angulaire du rotor (1) et un signal top tour (C) sous forme de N*M impulsions par tour du codeur (2), les M singularités (2b1) étant réparties angulairement de sorte que le signal top tour (C) soit agencé pour, en combinaison avec les signaux A et B, définir des séquences binaires de longueur angulaire inférieure à celle des secteur (2c) et qui sont représentatives de la position angulaire absolue du codeur (2) sur un secteur (2c) ;
- un circuit de commutation des courants dans les enroulements de phase du moteur qui comprend 2*P*N interrupteurs ;
- un circuit de commande du circuit de commutation qui est apte :
- lors de la lecture d'une séquence binaire, à déterminer l'état de la logique de commutation des courants dans les enroulements de phase qui correspond à la position angulaire absolue associée à ladite séquence binaire ;
- en fonction des signaux de position (A, B) détectés, à déterminer en continu l'état de la logique de commutation qui est adapté à la position angulaire du rotor (1);
- à fournir les signaux de commutation des interrupteurs qui correspondent à l'état de la logique déterminée par le signal top tour (C) ou par les signaux de position (A, B).

2. Dispositif selon la revendication 1, **caractérisé en ce que** chaque piste multipolaire (2a, 2b) est formée d'un anneau magnétique sur lequel sont aimantés des pôles (2d) Nord et Sud équirépartis avec une largeur angulaire constante, une singularité magnétique (2b1) de la piste top tour (2b) étant formée de deux pôles (2d) adjacents dont la transition magnétique est différente des autres.

3. Roulement du type comprenant une bague fixe (4) destinée à être associée à un organe fixe, une bague tournante (5) destinée à être mise en rotation par le rotor (1) du moteur électrique et des corps roulants (6) disposés entre lesdites bagues, ledit roulement étant **caractérisé en ce que** le codeur (2) d'un dispositif de pilotage selon l'une quelconque des revendications 1 ou 2 est associé à la bague tournante (5).

4. Roulement selon la revendication 3, **caractérisé en ce que** le codeur (2) est associé à la bague tournante (5) de sorte que la face extérieure dudit codeur soit sensiblement contenue dans le plan P d'une face latérale de la bague fixe (4).

5. Roulement selon la revendication 3 ou 4, **caractérisé en ce que** le codeur (2) est porté par une armature d'association (7).

6. Roulement selon l'une quelconque des revendications 3 à 5, **caractérisé en ce que** le capteur (3) du dispositif de pilotage est associé à la bague fixe (4) du roulement.

7. Moteur à commutation électronique équipé d'un dispositif de pilotage selon l'une quelconque des revendications 1 ou 2, du type comprenant un rotor (1) monté en rotation par l'intermédiaire d'un roulement selon la revendication 6.

8. Moteur à commutation électronique équipé d'un dispositif de pilotage selon l'une quelconque des revendications 1 ou 2, du type comprenant un rotor (1) monté en rotation par l'intermédiaire d'un roulement selon l'une quelconque des revendications 3 à 5, le capteur (3) étant associé à une pièce fixe (8) du moteur.

9. Moteur à commutation électronique équipé d'un dispositif de pilotage selon l'une quelconque des revendications 1 ou 2, du type comprenant un rotor (1) et une pièce fixe (8), dans lequel le codeur (2) est associé au rotor (1) et le capteur (3) est associé à la pièce fixe (8).

10. Procédé de pilotage d'un moteur selon l'une quelconque des revendications 7 à 9, **caractérisé en ce qu'**il comprend les étapes successives suivantes :
- application d'un couple sur le rotor (1) de sorte à permettre sa mise en rotation et donc celle du codeur (2) ;
- détection de la première séquence binaire ;
- détermination de l'état de la logique de commutation correspondant à la position angulaire absolue associée à ladite séquence binaire ;
- envoi au circuit de commutation des signaux de commutation correspondant à l'état déterminé ;
- détermination itérative des états de la logique de commutation ultérieurs à partir des signaux de position (A, B);
- envoi au circuit de commutation des signaux de commutation correspondant aux états déterminés.

11. Procédé selon la revendication 10, **caractérisé en ce qu'**il comprend une étape préalable d'indexation angulaire des impulsions top tour par rapport au passage à zéro des forces électromotrices dans les phases du moteur.

## Claims

1. A device for controlling an electric motor of the electronic changeover type comprising N pairs of poles and P phases, said device comprising:
- an encoder (2) intended to be rotated simultaneously with the rotor (1) of the motor, said encoder comprising a main multi-pole track (2a) and a so-called "top tour" multi-pole track (2b) which are concentric, said tracks comprising, each, N identical sectors (2c) angularly distributed respectively on the whole circumference of said tracks, the sectors (2c) of the top tour track (2b) comprising, each, angularly distributed M singularities (2b1), the angular distances separating each of the M singularities (2b1) being different from each other;
- a fixed sensor (3) positioned opposite and at a gap distance from the encoder (2), comprising at least three responsive elements, at least two of which are positioned opposite the main track (2a) so as to deliver two periodical electric signals in quadrature S1, S2 and at least one is positioned opposite the top tour track (2b) so as to deliver an electric signal S3, the sensor (3) comprising an electronic circuit capable of delivering, from signals S1, S2 and S3, two position (A, B) square digital signals in quadrature which are representative of the angular position of the rotor (1) and a top tour signal (C) in the form of N*M pulses per revolution of the encoder (2), the M singularities (2b 1) being angularly distributed so that the top tour signal (C) is arranged for defining, in combination with signals A and B, binary sequences having an angular length smaller than that of the sectors (2c) and which are representative of the absolute angular position of the encoder (2) on one sector (2c);
- a current changeover circuit in the phase windings of the motor which comprises 2*P*N switches;
- a changeover circuit control circuit which is capable of:
- during the reading of a binary sequence, determining the condition of the current changeover logic in the phase windings which corresponds to the absolute angular position associated with said binary sequence;
- according to the position signals (A, B) detected, continuously determining the condition of the changeover logic which is adapted to the angular position of the rotor (1);
- supplying the switches changeover signals which corresponds to the condition of the logic determined by the top tour signal (C) or by the position signals (A, B).

2. A device according to claim 1, **characterized in that** each multi-pole track (2a, 2b) is formed of a magnetic ring on which North and South poles (2d) are magnetized and equally distributed with a constant angular width, a magnetic singularity (2b1) of the top tour track (2b) being formed of two adjacent poles (2d), a magnetic transition of which is different from the other ones.

3. A bearing of the type comprising a fixed ring (4) intended to be associated with a fixed element, a rotating ring (5) intended to be rotated by the rotor (1) of the electric motor and rolling bodies (6) positioned between said rings, said bearing being **characterized in that** the encoder (2) of a control device according to any one of claims 1 or 2 is associated with the rotating ring (5).

4. A bearing according to claim 3, **characterized in that** the encoder (2) is associated with the rotating ring (5) so that the outer face of said encoder is substantially contained within plane P of a side face of the fixed ring (4).

5. A bearing according to claim 3 or 4, **characterized in that** the encoder (2) is supported by an association frame (7).

6. A bearing according to any one of claims 3 to 5, **characterized in that** the sensor (3) of the control device is associated with the fixed ring (4) of the bearing.

7. An electronic changeover motor equipped with a control device according to any one of claims 1 or 2, of the type comprising a rotor (1) rotatably mounted by means of a bearing according to claim 6.

8. An electronic changeover motor equipped with a control device according to any one of claims 1 or 2, of the type comprising a rotor (1) rotatably mounted by means of a bearing according to any one of claims 3 to 5, the sensor (3) being associated with a fixed part (8) of the motor.

9. An electronic changeover motor equipped with a control device according to any one of claims 1 or 2, of the type comprising a rotor (1) and a fixed part (8), wherein the encoder (2) is associated with the rotor (1) and the sensor (3) is associated with the fixed part (8).

10. A method for controlling a motor according to any one of claims 7 to 9, **characterized in that** it comprises the following successive steps:
- application of a torque onto the rotor (1) so as to allow its rotation and thus the rotation of the encoder (2);
- detection of the first binary sequence;
- determination of the condition of the changeover logic corresponding to the absolute angular position associated with said binary sequence;
- sending to the changeover circuit the changeover signals corresponding to the determined conditions;
- iterative determination of the subsequent conditions of the changeover logic from the position signals (A, B);
- sending to the changeover circuit the changeover signals corresponding to the determined conditions.

11. A method according to claim 10, **characterized in that** it comprises a previous step of angular indexing of the top tour pulses with respect to the zeroing of the electromotive forces in the motor phases.

## Patentansprüche

1. Steuervorrichtung eines Elektromotors des Typs mit elektronischer Umschaltung, mit N Polpaaren und P Phasen, wobei die genannte Vorrichtung umfaßt:
- einen Codierer (2), der gemeinsam mit dem Rotor (1) des Motors in Drehung versetzt werden soll, wobei der genannte Codierer eine mehrpolige Hauptbahn (2a) und eine mehrpolige "top tour" genannte Bahn (2b) umfaßt, die konzentrisch sind, wobei die genannten Bahnen jeweils N identische Sektoren (2c) umfassen, die jeweils winkelförmig über den gesamten Umfang der genannten Bahnen verteilt sind, wobei die Sektoren (2c) der Bahn "top tour" (2b) jeweils M Singularitäten (2b1) umfassen, die winkelförmig verteilt sind, wobei die jede der M Singularitäten (2b1) trennenden winkelförmigen Abstände sich voneinander unterscheiden;
- einen festen Sensor (3), der gegenüber und im Luftspaltabstand zum Codierer (2) angeordnet ist, mit mindestens drei empfindlichen Elementen, von denen mindestens zwei gegenüber der Hauptbahn (2a) positioniert sind, um zwei elektrische, in Quadratur periodische S1, S2 Signale zu liefern, und mindestens eins gegenüber der Bahn "top tour" (2b) positioniert ist, um ein elektrisches Signal S3 zu liefern, wobei der Sensor (3) einen elektronischen Schaltkreis umfaßt, der ab den Signalen S1, S2 und S3 zwei digitale, in Quadratur viereckige Positionssignale (A, B) liefert, die die Winkelposition des Rotors (1) wiedergeben, und ein Signal "top tour" (C) in Form von N*M Impulsen pro Umdrehung des Codierers (2), wobei die M Singularitäten (2b1) winkelförmig verteilt sind, so dass das Signal "top tour" vorgesehen ist, um kombiniert mit den Signalen A und B binäre Sequenzen von einer Winkellänge kleiner als diejenige der Sektoren (2c) zu definieren, und die die absolute Winkelposition des Codierers (2) auf einem Sektor (2c) wiedergeben;
- einen Umschaltkreis der Ströme in den Phasenwicklungen des Motors, der 2*P*N Schalter umfaßt;
- einen Steuerkreis des Umschaltkreises, der
. beim Auslesen einer binären Sequenz den Zustand der Umschaltlogik der Ströme in den Phasenwicklungen ermitteln kann, der der absoluten, der genannten binären Sequenz zugeordneten Winkelposition entspricht;
. je nach den erfaßten Positionssignalen (A, B) kontinuierlich den Zustand der Umschaltlogik ermitteln kann, der der Winkelposition des Rotors (1) angepaßt ist;
. Umschaltsignale der Schalter liefern kann, die dem Zustand der von dem Signal "top tour" (C) oder von den Positionssignalen (A, B) bestimmten Logik entsprechen.

2. Vorrichtung gemäß Anspruch 1, **dadurch gekennzeichnet, dass** jede mehrpolige Bahn (2a, 2b) aus einem Magnetring gebildet wird, an dem Nord- und Südpol (2d) in gleichen Abständen mit konstanter Winkelbreite magnetisiert sind, wobei eine magnetische Singularität (2b1) der Bahn "top tour" (2b) aus zwei aneinander grenzenden Polen (2d) besteht, deren magnetischer Übergang sich von den anderen unterscheidet.

3. Wälzlager des Typs mit einem festen Ring (4), der mit einem festen Organ verbunden werden soll, einem drehbaren Ring (5), der von dem Rotor (1) des Elektromotors in Drehung versetzt werden soll, und zwischen den genannten Ringen angeordneten Wälzkörpern (6), wobei das genannte Wälzlager **dadurch gekennzeichnet ist, dass** der Codierer (2) einer Steuervorrichtung gemäß einem der Ansprüche 1 oder 2 dem drehbaren Ring (5) zugeordnet ist.

4. Wälzlager gemäß Anspruch 3, **dadurch gekennzeichnet, dass** der Codierer (2) derart dem drehbaren Ring (5) zugeordnet ist, dass die Aussenfläche des genannten Codierers etwa in der Ebene P einer Seitenfläche des festen Rings (4) enthalten ist.

5. Wälzlager gemäß Anspruch 3 oder 4, **dadurch gekennzeichnet, dass** der Codierer (2) von einer Verbindungsarmatur (7) getragen wird.

6. Wälzlager gemäß einem der Ansprüche 3 bis 5, **dadurch gekennzeichnet, dass** der Sensor (3) der Steuervorrichtung dem festen Ring (4) des Wälzlagers zugeordnet ist.

7. Motor mit elektronischer Umschaltung, ausgestattet mit einer Steuervorrichtung gemäß einem der Ansprüche 1 oder 2, des Typs mit einem Rotor (1), der drehbar über ein Wälzlager gemäß Anspruch 6 montiert ist.

8. Motor mit elektronischer Umschaltung, ausgestattet mit einer Steuervorrichtung gemäß einem der Ansprüche 1 oder 2, des Typs mit einem Rotor (1), der drehbar über ein Wälzlager gemäß Anspruch 3 bis 5 montiert ist, wobei der Sensor (3) mit einem festen Teil (8) des Motors verbunden ist.

9. Motor mit elektronischer Umschaltung, ausgestattet mit einer Steuervorrichtung gemäß einem der Ansprüche 1 oder 2, des Typs mit einem Rotor (1) und einem festen Teil (8), bei dem der Codierer (2) mit dem Rotor (1) und der Sensor (3) mit dem festen Teil (8) verbunden ist.

10. Steuerverfahren eines Motors gemäß einem der Ansprüche 7 bis 9, **dadurch gekennzeichnet, dass** es die folgenden aufeinanderfolgenden Schritte umfaßt:
- Beaufschlagung des Rotors (1) mit einem Moment, um seine Drehung sowie diejenige des Codierers (2) auszulösen;
- Erfassung der ersten binären Sequenz;
- Ermittlung des Zustands der Umschaltlogik entsprechend der der genannten binären Sequenz zugeordneten absoluten Winkelposition;
- Versand an den Umschaltkreis der dem ermittelten Zustand entsprechenden Umschaltsignale;
- iterative Ermittlung der späteren Zustände der Umschaltlogik ab den Positionssignalen (A, B);
- Versand an den Umschaltkreis der den ermittelten Zuständen entsprechenden Umschaltsignale.

11. Verfahren gemäß Anspruch 10, **dadurch gekennzeichnet, dass** es einen vorherigen Schritt der Winkelindexierung der Impulse "top tour" in bezug auf den Nulldurchlauf der elektromotorischen Kräfte in den Phasen des Motors umfaßt.
